# EUROPÄISCHE PATENTSCHRIFT

(11) **EP 2 888 745 B1**
(45) Veröffentlichungstag und Bekanntmachung des Hinweises auf die Patenterteilung: **15.01.2020**
(21) Anmeldenummer: 13745086.2
(22) Anmeldetag: 02.08.2013
(51) Int. Cl.: H01C 1/01, H01C 1/084, H01C 7/00, H01C 7/02, H01C 7/04, H01C 7/102, H05K 1/02, H05K 1/11

(54) **ELEKTRISCHE BAUELEMENTANORDNUNG**
ELECTRIC COMPONENT ASSEMBLY
ENSEMBLE COMPOSANT ÉLECTRIQUE

(30) Priorität: 21.08.2012 DE 102012107668
(43) Veröffentlichungstag der Anmeldung: 01.07.2015
(73) Patentinhaber: TDK Electronics AG, 81671 München (DE)
(72) Erfinder: BRUNNER, Sebastian, A-8042 Graz (AT); FEICHTINGER, Thomas, A-8010 Graz (AT)
(74) Vertreter: Epping - Hermann - Fischer
(86) Internationale Anmeldenummer: PCT/EP2013/066326
(87) Internationale Veröffentlichungsnummer: WO 2014/029602

(56) Entgegenhaltungen:
- EP-A1- 2 031 952
- DE-A1-102010 012 042
- JP-A- 2011 009 399
- US-A- 5 625 222
- US-A1- 2010 164 092
- US-A1- 2011 057 273

## Beschreibung

Es wird eine Bauelementanordnung angegeben, die einen Träger und wenigstens ein elektrisches Bauelement aufweist.

Beispielsweise weist die Bauelementanordnung einen Leuchtdiodenchip auf.

Es sind Licht emittierende Dioden bekannt, bei denen ein LED-Chip und ein Schutzbauelement auf einem ebenen Träger angeordnet sind.

Die Druckschriften JP 2011 009399 A, US 5 625 222 A und US 2011/057273 A1 zeigen jeweils eine Bauelementanordnung, bei denen ein Bauelement in einer Kavität in einem isolierenden Träger angeordnet ist. Die Druckschrift EP 2 031 952 A1 zeigt eine Bauelementanordnung, bei der mehrere elektronische Komponenten in einem metallischen Gehäuse angeordnet sind. Die Druckschrift US 2010/0164092 A1 beschreibt einen Halbleiterchip, der in einer stufenförmigen Vertiefung angeordnet ist und mit einer Schaltungsstruktur elektrisch verbunden ist.

Es ist eine Aufgabe, eine Bauelementanordnung mit verbesserten Eigenschaften anzugeben.

Diese Aufgabe wird durch einen Gegenstand gemäß dem unabhängigen Patentanspruch gelöst. Vorteilhafte Ausführungsformen und Weiterbildungen des Gegenstandes gehen weiterhin aus den abhängigen Patentansprüchen, der nachfolgenden Beschreibung und aus den Zeichnungen hervor.

Es wird eine Bauelementanordnung mit einem Träger angegeben. Der Träger weist vorzugsweise einen Grundkörper, insbesondere einen isolierenden Grundkörper, auf. Die Außenseiten des Trägers sind vorzugsweise frei von Kavitäten.

Beispielsweise kann der Grundkörper ein keramisches oder ein organisches Material aufweisen. Beispielsweise weist der Grundkörper mindestens eines der Materialien Aluminiumoxid, Aluminiumnitrid, Silicium oder eine Keramik des Typs LTCC ("low temperature cofired ceramics") auf oder besteht aus einem dieser Materialien. Der Träger kann als Leiterplatte, auf Englisch "printed circuit board", ausgebildet sein. Insbesondere kann der Träger wenigstens eine Kontaktfläche zur Kontaktierung eines elektrischen Bauelements aufweisen. Die Kontaktfläche kann als Metallisierung einer Außenseite des Trägers ausgebildet sein.

Beispielsweise ist die Kontaktfläche lötbar. Alternativ oder zusätzlich kann die Kontaktfläche bondbar sein.

Der Träger weist eine metallische Struktur auf. Die metallische Struktur ist vorzugsweise an einer Außenseite des Trägers angeordnet. Die metallische Struktur weist wenigstens eine Kavität auf. Die metallische Struktur ist frei von Abknickungen oder Krümmungen.

Die metallische Struktur kann beispielsweise galvanisch auf den Träger aufgebracht sein. Insbesondere kann ein metallisches Material galvanisch auf dem Träger abgeschieden sein. Beispielsweise weist das metallische Material Kupfer auf oder besteht aus Kupfer. Vorzugsweise ist die metallische Struktur schichtförmig ausgebildet.

Die Kavität ist beispielsweise durch eine Vertiefung in der metallischen Struktur ausgebildet. Die Vertiefung kann bis zum Träger, beispielsweise bis zum Grundkörper oder einer Kontaktfläche des Trägers reichen. Insbesondere kann die Kavität durch eine Aussparung gebildet sein, die vollständig durch die metallische Struktur hindurchführt.

Vorzugsweise ist wenigstens ein elektrisches Bauelement zumindest teilweise in der Kavität angeordnet.

Vorzugsweise ist das wenigstens eine elektrische Bauelement ein diskretes elektrisches Bauelement. Beispielsweise ist das elektrische Bauelement als Varistor ausgebildet. Insbesondere kann der Varistor in Form eines Mehrschichtvaristors, auch als Multi-Layer-Varistor (MLV) bezeichnet, ausgeführt sein. Beispielsweise ist der Varistor als ESD-Schutzbauelement ausgebildet. Alternativ kann das elektrische Bauelement auch als TVS-Diode, als NTC-Thermistorbauelement, PTC-Thermistorbauelement oder als Leuchtdiode ausgeführt sein. Das elektrische Bauelement kann auch als Chip, insbesondere als Leuchtdiodenchip ausgeführt sein.

Vorzugsweise ist das elektrische Bauelement vollständig in der Kavität versenkt.

Dass ein Bauelement in einer Kavität "vollständig versenkt angeordnet" ist, bedeutet insbesondere, dass die Kavität eine Tiefe aufweist, die größer oder gleich einer Höhe des in der Kavität angeordneten Bauteils ist, so dass kein Bereich des Bauteils über die Kavität hinausragt.

Bei einer vollständigen Versenkung des Bauelements ist eine besonders kompakte Ausgestaltung der Bauelementanordnung möglich. Beispielsweise kann auf die metallische Struktur ein weiteres Element, insbesondere ein weiteres elektrisches Bauelement oder ein weiterer Träger aufgebracht sein. Durch die vollständige Versenkung des elektrischen Bauelements in der Kavität kann das weitere Element auf der metallischen Struktur über dem elektrischen Bauelement angeordnet werden.

Die metallische Struktur kann somit insbesondere als Abstandshalter, auch als "Standoff" bezeichnet, dienen. Insbesondere kann ein weiteres Element, das auf dem Träger aufgebracht wird, durch die metallische Struktur in einem vorgegebenen Abstand von der Außenseite des Trägers angeordnet werden. Der Abstand ist vorzugsweise derart, dass ein elektrisches Bauelement zwischen dem Träger und dem weiteren Element angeordnet werden kann.

Die metallische Struktur weist wenigstens zwei voneinander getrennte Teilbereiche auf.

Die Teilbereiche sind beispielsweise in einem Abstand voneinander angeordnet. Die Kavität ist zwischen den Teilbereichen ausgebildet. Beispielsweise sind die Teilbereiche durch einen Spalt voneinander getrennt. In einer Ausführungsform kann jeder Teilbereich eine rechteckige äußere Form, beispielsweise mit abgerundeten Ecken, aufweisen.

Vorzugsweise weisen die Teilbereiche planare Oberflächen auf.

Insbesondere kann die Oberfläche parallel zur Außenseite des Trägers verlaufen. Weiterhin können die Oberflächen der Teilbereiche frei von Vertiefungen sein. Bei planaren Oberflächen der Teilbereiche kann ein weiteres Element, insbesondere ein weiteres elektrisches Bauelement oder ein Träger, besonders gut auf den Teilbereichen angeordnet werden.

In einer Ausführungsform weist die metallische Struktur wenigstens zwei Teilbereiche auf, die die gleiche Höhe aufweisen. In diesem Fall kann ein weiteres Element horizontal auf den zwei Teilbereichen angeordnet werden, so dass das weitere Element insbesondere nicht gegenüber der ihm zugewandten Außenseite des Trägers geneigt ist.

Beispielsweise kann der Träger auch auf einen weiteren Träger oder auch ein weiteres Element aufgebracht werden. Die metallische Struktur kann zur Verbindung des Trägers mit dem weiteren Träger oder dem weiteren Element dienen.

Die metallische Struktur kann mehr als zwei Teilbereiche mit gleicher Höhe aufweisen. Beispielsweise weist die metallische Struktur drei Teilbereiche mit gleicher Höhe auf. Weiterhin kann die metallische Struktur neben den Teilbereichen mit gleicher Höhe ein oder mehrere Teilbereiche mit anderen Höhen aufweisen. Somit kann die metallische Struktur eine stufenförmige Oberfläche aufweisen. Beispielsweise weist die metallische Struktur zwei Teilbereiche mit gleicher Höhe und einen dritten Teilbereich mit einer niedrigeren Höhe auf. Beispielsweise kann auf den dritten Teilbereich ein weiteres Bauelement aufgebracht sein. Dabei kann der dritte Teilbereich inklusive des weiteren Bauelements eine geringere Höhe aufweisen als jeweils der erste und zweite Teilbereich.

Erfindungsgemäß ist die metallische Struktur nicht mit einem elektrischen Kontakt verbunden.

Beispielsweise dient die metallische Struktur als Abstandshalter für ein weiteres Element und/oder zur Wärmeabfuhr.

In einer Ausführungsform weist der Träger wenigstens eine Via auf.

Die Via kann als thermische Via ausgeführt sein. Eine thermische Via kann eine Abführung von Wärme verbessern. Beispielsweise kann durch die thermische Via Wärme von einem elektrischen Bauelement, beispielsweise einem Leuchtdiodenchip, abgeführt werden. Vorzugsweise weist die thermische Via ein Material mit einer guten thermischen Leitfähigkeit auf. Beispielsweise weist die zumindest eine Via Kupfer, Silber oder Silber-Palladium auf oder besteht daraus. Die Via kann vollständig oder teilweise mit einem Material gefüllt sein. Beispielsweise kann die Via als Hülse ausgeführt sein. Beispielsweise kann die Via durch den Träger von einer Oberseite bis zu einer Unterseite führen.

Durch die Via kann die Wärme auf die metallische Struktur abgeleitet werden. Der Leuchtdiodenchip ist beispielsweise auf einer Oberseite des Trägers angeordnet und mit der Via thermisch verbunden. Die metallische Struktur ist beispielsweise auf einer Unterseite des Trägers angeordnet und ebenfalls mit der Via thermisch verbunden. Somit kann Wärme über die Via zur metallischen Struktur hin abgeführt werden.

Die Bauelementanordnung kann mehrere Vias aufweisen, wobei die Vias thermisch und/oder elektrisch mit Teilbereichen der metallischen Struktur kontaktiert sein können. Beispielsweise können ein oder mehrere Vias nur thermisch mit einem ersten Teilbereich kontaktiert sein. Weitere Vias können elektrisch mit einem zweiten Teilbereich kontaktiert sein.

In einer Ausführungsform weist die metallische Struktur mehrere Kavitäten auf. In einer oder in mehreren der Kavitäten können elektrische Bauelemente angeordnet sein. Beispielsweise ist in jeder der Kavitäten ein elektrisches Bauelement angeordnet. Vorzugsweise sind die Bauelemente vollständig in der metallischen Struktur versenkt.

In einer Ausführungsform können in einer Kavität mehrere elektrische Bauelemente angeordnet sein. Vorzugsweise sind die elektrischen Bauelemente vollständig in der Kavität versenkt.

In einer Ausführungsform ist die Kavität zumindest teilweise von einem weiteren Element überdeckt.

Das weitere Element kann beispielsweise als Träger und/oder als elektrisches Bauelement ausgebildet sein. Das weitere Element kann wie oben beschrieben auf der metallischen Struktur, insbesondere auf Teilbereiche der metallischen Struktur angeordnet sein. Das weitere Element kann die Kavität vollständig überdecken. Das elektrische Bauelement kann somit in der Bauelementanordnung zwischen dem Träger und dem weiteren Element eingebettet sein.

Die metallische Struktur kann zur Befestigung des weiteren Elements am Träger ausgebildet sein. Insbesondere kann das weitere Element an der metallischen Struktur angelötet sein.

Im Folgenden werden die hier beschriebenen Gegenstände anhand von schematischen und nicht maßstabsgetreuen Ausführungsbeispielen näher erläutert.

Es zeigen:
- Figur 1: in einem schematischen Schnittbild eine Bauelementanordnung, die kein Ausführungsbeispiel der Erfindung darstellt sofern die metallische Struktur elektrisch kontaktiert ist,
- Figur 2: in einer perspektivischen Ansicht die Bauelementanordnung aus Figur 1,
- Figuren 3A bis 3G: in schematischen Schnittbildern Verfahrensschritte bei der Herstellung einer Bauelementanordnung, die kein Ausführungsbeispiel der Erfindung darstellt sofern die metallische Struktur elektrisch kontaktiert ist,
- Figuren 4 bis 7: in schematischen Schnittbildern weitere Bauelementanordnungen, die keine Ausführungsbeispiele der Erfindung darstellen sofern die metallische Struktur elektrisch kontaktiert ist,
- Figuren 8 bis 10: in schematischen Schnittbildern verschiedene Gestaltungsmöglichkeiten von Bauelementanordnungen, die keine Ausführungsbeispiele der Erfindung darstellen sofern die metallische Struktur elektrisch kontaktiert ist.

Vorzugsweise verweisen in den folgenden Figuren gleiche Bezugszeichen auf funktionell oder strukturell entsprechende Teile der verschiedenen Ausführungsformen.

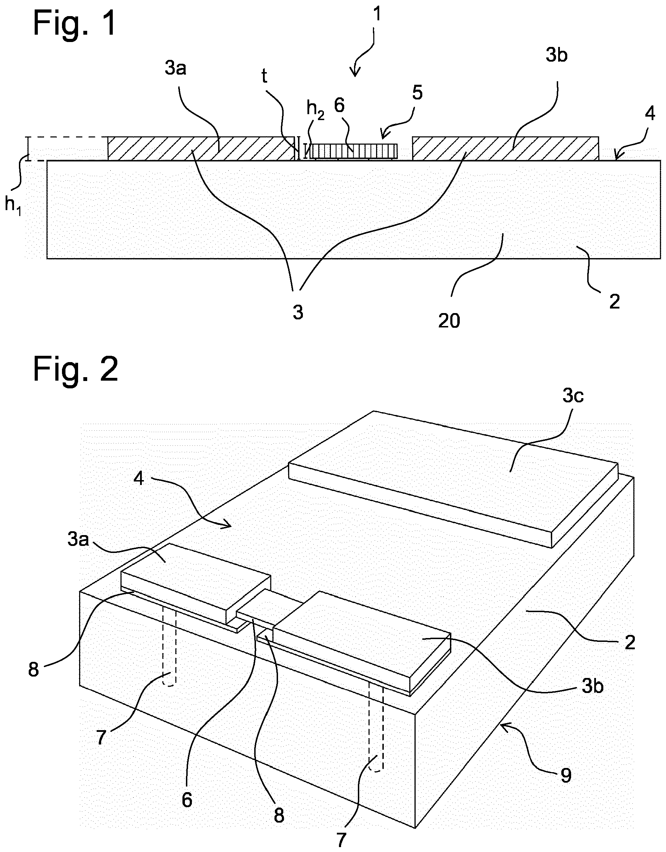

Figur 1 zeigt in einem schematischen Schnittbild eine Bauelementanordnung 1. Die Bauelementanordnung 1 weist einen Träger 2 auf. Vorzugsweise weist der Träger 2, insbesondere ein Grundkörper 20 des Trägers, ein elektrisch isolierendes Material auf. Beispielsweise weist der Träger 2 ein keramisches Material oder ein organisches Material auf.

Der Träger 2 weist auf einer ersten Außenseite 4 eine metallische Struktur 3, insbesondere eine schichtförmige metallische Struktur 3, auf. Die metallische Struktur 3 ist beispielsweise durch galvanische Abscheidung gebildet.

Die vom Träger 2 abgewandte Außenseite 19 der metallischen Struktur 3 verläuft parallel zur ersten Außenseite 4 des Trägers. Beispielsweise ist die erste Außenseite 4 eine Unterseite des Trägers 2. Die metallische Struktur 3 weist insbesondere eine planare Oberfläche 19 auf, die es ermöglicht, den Träger eben zu platzieren oder ein weiteres Element auf der Oberfläche 19 eben anzuordnen.

Beispielsweise weist die Struktur 3 Kupfer auf. Weiterhin kann die metallische Struktur 3 auf einer Oberfläche mit einer dünnen Schicht, beispielsweise einer Goldschicht, zur Verbesserung der Lötbarkeit versehen sein. Die Struktur kann beispielsweise eine Höhe im Bereich von 80 µm - 90 µm aufweisen. Dabei ist die Höhe vorzugsweise derart gewählt, dass ein elektrisches Bauelement vollständig in die metallische Struktur eingebettet werden kann. Beispielsweise kann die Höhe auch im Bereich von 120 µm liegen. Die Struktur 3 kann vollständig metallisch ausgebildet sein.

Die Struktur 3 weist mehrere voneinander getrennte Teilbereiche 3a, 3b auf. Die Teilbereiche 3a, 3b sind jeweils schichtförmig ausgebildet und weisen die gleiche Höhe h₁ auf, die der Höhe der Struktur entspricht. Beispielsweise sind die Teilbereiche 3a, 3b als Kontaktpads ausgebildet.

Zwischen den Teilbereichen 3a, 3b befindet sich eine Kavität 5, in der ein elektrisches Bauelement 6 angeordnet. Das elektrische Bauelement 6 ist vollständig in der Kavität 5 versenkt, so dass die vom Träger 2 wegweisende Oberfläche des Bauelements 6 nicht über die metallische Struktur 3 herausragt. Die Höhe h₂ des Bauelements 6 ist insbesondere geringer als die Tiefe t der Kavität 5.

Das elektrische Bauelement 6 ist ein diskretes Bauelement. Beispielsweise ist das elektrische Bauelement 6 als Varistor ausgebildet. Insbesondere kann der Varistor in Form eines Mehrschichtvaristors, auch als Multi-Layer-Varistor (MLV) bezeichnet, ausgeführt sein. Beispielsweise ist der Varistor als ESD-Schutzbauelement ausgebildet. Alternativ kann das elektrische Bauelement 6 auch als TVS-Diode, als NTC-Thermistorbauelement, PTC-Thermistorbauelement oder als Leuchtdiode ausgeführt sein. Das elektrische Bauelement 6 kann auch als Chip, insbesondere als Leuchtdiodenchip ausgeführt sein.

Das elektrische Bauelement 6 ist vorzugsweise ultradünn ausgebildet. Insbesondere kann das elektrische Bauelement 6 eine Höhe von unter 100 µm, beispielsweise eine Höhe von 80 µm aufweisen. Entsprechend kann die Kavität eine Tiefe t von unter 150 µm, beispielsweise von 120 µm aufweisen. Die Tiefe t der Kavität 5 kann der Höhe der metallischen Struktur 3 entsprechen.

Figur 2 zeigt eine perspektivische Ansicht der Bauelementanordnung aus Figur 1. Der Träger 2 ist mit Kontaktflächen 8 (in Figur 1 nicht abgebildet) versehen, auf denen die Teilbereiche 3a, 3b der metallischen Struktur 3 des Trägers 2 aufgebracht sind. Die Kontaktflächen 8 sind vorzugsweise dünne metallische Schichten und können insbesondere Kupfer mit einer dünnen Goldschicht zur Verbesserung der Lötbarkeit aufweisen. Beispielsweise weisen die Kontaktflächen 8 Dicken im Bereich von 20 µm auf. Das elektrische Bauelement 6 ist ebenfalls auf den Kontaktflächen 8 aufgebracht. Vorzugsweise ist das Bauelement 6 auf den Kontaktflächen 8 angelötet.

Im Träger 2 sind Vias 7, d.h. Durchkontaktierungen, angeordnet. Die Vias 7 dienen zur elektrischen Kontaktierung der Kontaktflächen 8. Zusätzlich können die Vias 7 auch als thermische Vias ausgeführt sein und zur Wärmeabfuhr dienen. Die Teilbereiche 3a, 3b sind jeweils mit einer Via 7 elektrische kontaktiert. Somit können die Teilbereiche 3a, 3b zur Kontaktierung eines weiteren Elements eingesetzt werden.

Die Vias 7 weisen beispielsweise Kupfer auf. Alternativ können die Vias 8 auch andere Materialien mit einer hohen Wärmeleitfähigkeit, wie zum Beispiel Silber oder Silber-Palladium, aufweisen.

Die metallische Struktur 3 weist einen dritten Teilbereich 3c (in Figur 1 nicht abgebildet) auf. Dieser Teilbereich 3c kann beispielsweise ebenfalls zur elektrischen Kontaktierung und/oder zur Wärmeabfuhr dienen und mit elektrischen und/oder thermischen Vias verbunden sein. Vorzugsweise ist dieser Teilbereich 3a nicht elektrisch kontaktiert und insbesondere isolierend zu daran angrenzenden thermischen Vias. Beispielsweise ist der Teilbereich 3a als Wärmeleitpad ausgebildet.

Beispielsweise ist auf einer zweiten Außenseite 9 des Trägers 2, die der ersten Außenseite 4 gegenüberliegt, ein Wärme erzeugendes Bauelement angeordnet. Dies kann insbesondere ein Leuchtdiodenchip 4 sein. Durch den Träger 2 führende Vias können die Wärme durch den Träger 2 hindurch auf den dritten Teilbereiche 3c ableiten. Beispielsweise ist die zweite Außenseite 9 eine Oberseite der Bauelementanordnung 1.

Der dritte Teilbereich 3c weist die gleiche Höhe auf wie der erste und zweite Teilbereich 3a, 3b. Somit kann ein weiteres Element auf den drei Teilbereichen 3a, 3b, 3c horizontal angeordnet werden.

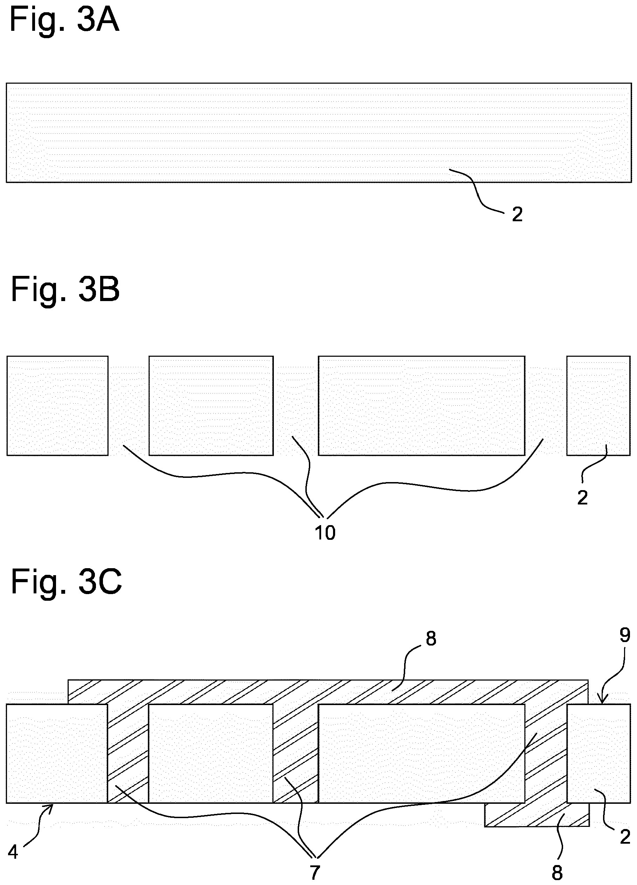

Die Figuren 3A bis 3G zeigen in schematischen Schnittbildern Verfahrensschritte bei der Herstellung einer Bauelementanordnung.

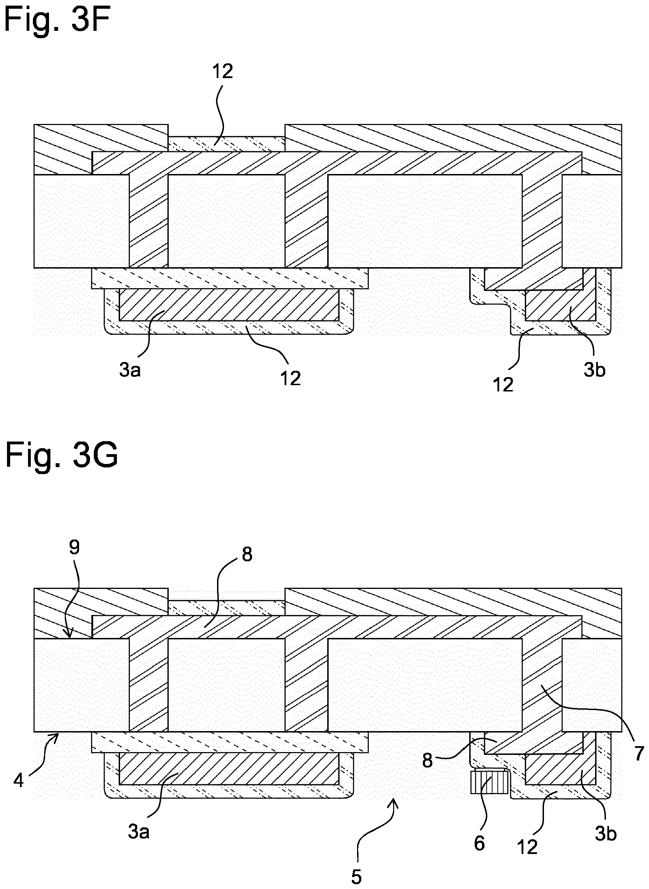

Die in Figur 3G gezeigte resultierende Bauelementanordnung ist ein weiteres Beispiel für eine Bauelementanordnung und unterscheidet sich in der spezifischen Anordnung der verschiedenen Bestandteile von der in den Figuren 1 und 2 gezeigten Bauelementanordnung, jedoch kann das Verfahren analog zur Herstellung der in den Figuren 1 und 2 gezeigten Bauelementanordnung und den in nachfolgenden Figuren gezeigten Bauelementanordnung angewandt werden.

Gemäß Figur 3A wird ein Träger 2 bereitgestellt. Der Träger 2 ist vorzugsweise aus einem isolierenden Material, insbesondere kann der Träger 2 wie zu den Figuren 1 und 2 beschrieben ausgebildet sein.

Gemäß Figur 3B werden in einem anschließenden Verfahrensschritt Durchführungen 10 zur Ausbildung von Vias in den Träger 2 eingebracht, beispielsweise eingestanzt. Dies kann beispielsweise mechanisch, insbesondere mit Nadeln, oder mit einem Laser erfolgen.

Gemäß Figur 3C werden die Durchführungen 10 mit einem metallischen Material befüllt, so dass Vias 7 gebildet werden. Zudem werden Kontaktflächen 8 auf erste und zweite Außenseiten 4, 9 des Trägers 1 aufgebracht, so dass die Kontaktflächen 8 mit den Vias 7 kontaktiert sind. Insbesondere können die Kontaktflächen 8 in einem Siebdruckverfahren aufgebracht werden. Die Kontaktflächen 8 weisen beispielsweise Kupfer oder Silber auf. Beispielsweise weisen die Kontaktflächen eine Höhe von um die 20 µm auf.

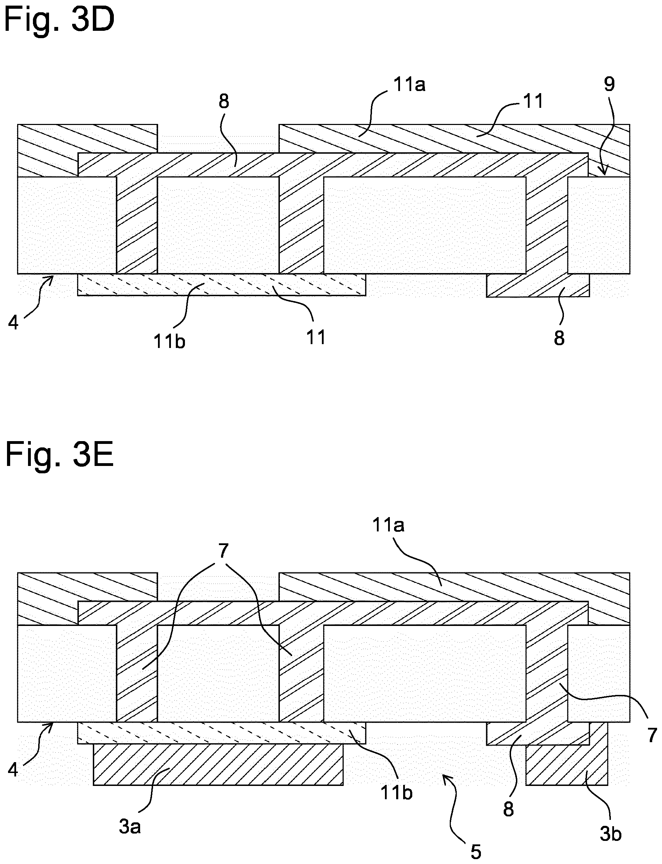

Gemäß Figur 3D wird auf Teile der Kontaktflächen 8 und Außenseiten 4, 9 des Trägers 2 eine elektrische Isolierung 11 aufgebracht. Die Isolierung 11 ist schichtförmig ausgebildet. Die Isolierung 11 kann in einem ersten Schritt derart aufgebracht werden, dass die Kontaktflächen 8 und die Außenseiten 4, 9 des Trägers 2 vollständig von der Isolierung 11 bedeckt sind. Anschließend kann die Isolierung 11 derart strukturiert werden, dass Teilbereiche der Kontaktflächen 8 und/oder der Außenseiten 4, 9 des Trägers 2 freiliegen. Die freiliegenden Bereiche der Kontaktflächen 8 dienen beispielsweise zur Kontaktierung eines elektrischen Bauelements.

Beispielsweise wird auf eine an einer zweiten Außenseite 9 angeordneten Kontaktfläche 8 eine erste Isolierung 11a aufgebracht. Die erste Isolierung 11a weist beispielsweise einen Glasanteil auf und kann als Glaspaste aufgedruckt werden. Alternativ kann die erste Isolierung 11a Siliciumnitrid (Si₃N₄) oder Aluminiumnitrid (AlN) aufweisen und beispielsweise durch plasmaunterstützte chemische Gasphasenabscheidung oder durch reaktives Sputtern aufgebracht werden. Eine Strukturierung der ersten Isolierung 11a kann dann mittels einer Ätzmaske erfolgen.

Auf einer an einer ersten Außenseite 4 angeordneten Kontaktfläche wird eine zweite Isolierung 11b aufgebracht. Die zweite Isolierung 11b weist ein Material mit einer hohen thermischen Leitfähigkeit auf. Beispielsweise weist die zweite Isolierung 11b Aluminiumnitrid auf. Die zweite Isolierung 11b kann abgeschieden werden.

Gemäß Figur 3E wird nun auf der ersten Außenseite 4 eine metallische Struktur 3 aufgebracht, insbesondere galvanisch abgeschieden. Beispielsweise kann hierzu das Verfahren einer semi-additiven Beschichtung angewandt werden, bei dem ein strukturierter Resist, z. B. Photolack, auf einer Keimschicht (engl. "seed layer") aufgebracht wird. Alternativ kann eine Kupferschicht aufgebracht, mit einem strukturierten Ätzresist versehen und dann subtraktiv geätzt werden.

Die metallische Struktur 3 weist einen ersten und einen zweiten Teilbereich 3a, 3b auf. Der erste Teilbereich 3a ist auf der zweiten Isolierung 11b angeordnet, so dass kein elektrischer Kontakt zu den Vias 7 hergestellt wird. Aufgrund der hohen Wärmeleitfähigkeit der zweiten Isolierung 11b kann eine Wärmeabfuhr von den oberhalb des ersten Teilbereichs 3a angeordneten Vias 7 zu dem ersten Teilbereich 3a erfolgen. Weiterhin wird auf eine freiliegende Kontaktfläche 8 auf der ersten Außenseite 4 ein zweiter Teilbereich 3b der metallischen Struktur 3 aufgebracht. Der zweite Teilbereich 3b steht mit der darüber angeordneten Via 7 in elektrischem Kontakt (nicht-erfindungsgemäß). Der zweite Teilbereich 3b kann zur elektrischen Kontaktierung eines weiteren Elements, das auf dem zweiten Teilbereich 3b angeordnet werden kann, dienen (nicht-erfindungsgemäß).

Der zweite Teilbereich 3b überdeckt die Kontaktfläche 8, mit der er in elektrischem Kontakt steht (nicht-erfindungsgemäß), nur teilweise, so dass ein Bereich der Kontaktfläche 8 freiliegt. Dieser Bereich der Kontaktfläche 8 kann zur Kontaktierung eines Bauelements genutzt werden.

In alternativen Ausführungsformen können beispielsweise mehrere oder alle Teilbereiche 3a, 3b elektrisch kontaktiert sein (nicht-erfindungsgemäß). Erfindungsgemäß ist keiner der Teilbereiche 3a, 3b elektrisch kontaktiert.

Die Teilbereiche 3a, 3b sind voneinander beabstandet, so dass zwischen den Teilbereichen 3a, 3b eine Kavität 5 ausgebildet ist.

Gemäß Figur 3F werden die freiliegenden Bereiche der Kontaktflächen 8 sowie die Teilbereiche 3a, 3b der metallischen Struktur 3 mit einer dünnen metallischen Schicht 12 versehen. Die Schicht 12 ist beispielsweise eine dünne Goldschicht und kann zur Verbesserung der Lötbarkeit dienen. Alternativ kann die Schicht 12 Nickel-Palladium-Gold oder Ni-Gold aufweisen. Die dünne Schicht 12 kann als Bestandteil der Teilbereiche 3a, 3b der metallischen Struktur angesehen werden.

Gemäß Figur 3G wird anschließend ein elektrisches Bauelement 6, insbesondere ein diskretes elektrisches Bauelement 6, in der Kavität 5 angeordnet. Das elektrische Bauelement 6 ist direkt neben dem zweiten Teilbereich 3b angeordnet. Das elektrische Bauelement 6 ist auf einem Teil der mit dem zweiten Teilbereich 3b kontaktierten Kontaktfläche 8 angeordnet, der nicht von dem zweiten Teilbereich 3b bedeckt ist. Das elektrische Bauelement 6 steht mit der Kontaktfläche 8 und der darüber angeordneten Via 7 in elektrischem Kontakt.

Beispielsweise ist das Bauelement 6 auf der Kontaktfläche 8, insbesondere auf der dünnen Schicht 12 der Kontaktfläche 8, angelötet. Alternativ kann das Bauelement 6 auch angeklebt, insbesondere mit einem Leitkleber angeklebt sein. Beispielsweise wird hierzu ein silberhaltiger Leitkleber verwendet. Alternativ kann das Bauelement 6 auch an die Kontaktfläche 8 gebondet sein. Beispielsweise kann das Bauelement 6 mittels Thermoschall-Bondens (engl. "thermosonic bonding"), Thermokompressions-Bondens (engl. "thermocompression bonding") oder einer Ultraschall-Flipchip-Gold-zu-Gold-Verbindung (engl. "ultrasonic flip chip gold-togold interconnect") mit der Kontaktfläche 8 verbunden sein.

Das elektrische Bauelement 6 ist vorliegend vollständig in der Kavität 5 versenkt, so dass es nicht über die metallische Struktur 3 aufweisend die dünne Schicht 12 hinaus steht.

Auf der zweiten Außenseite 9 des Trägers können ein oder mehrere weitere Bauelement aufgebracht werden. Beispielsweise kann ein weiteres Bauelement, wie z. B. ein Leuchtdiodenchip auf der Kontaktfläche 8, die mit einer dünnen Schicht 12 versehen ist, angeordnet und elektrisch kontaktiert werden. Der erste Teilbereich 3a kann zur Abfuhr von im weiteren Bauelement erzeugten Wärme dienen.

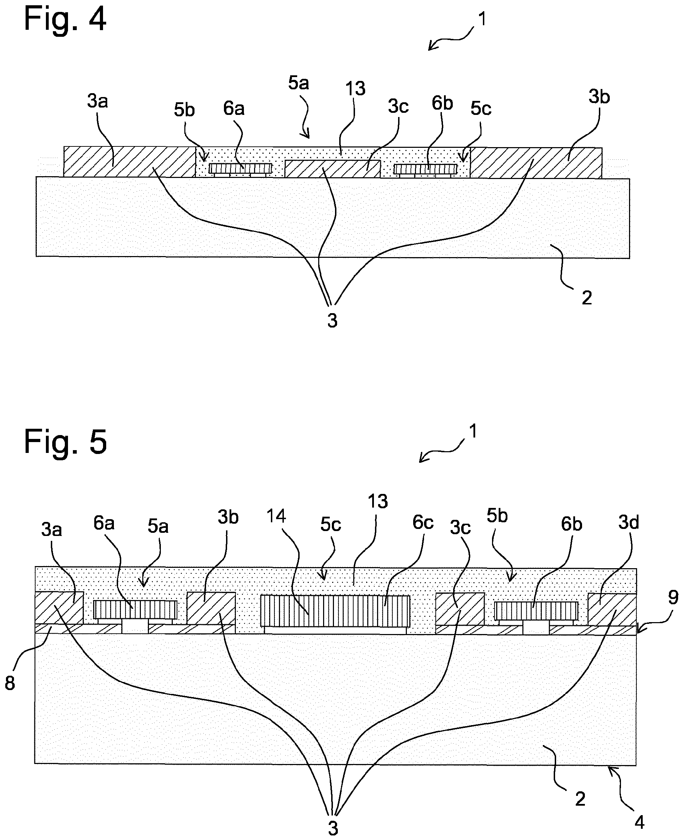

Die weiteren Figuren 4 bis 10 zeigen Ausführungsbeispiele und Gestaltungsmöglichkeiten einer Bauelementanordnung, die Modifikationen und Varianten der in den Figuren 1, 2 und 3G gezeigten Ausführungsbeispiele sind und die daher vor allem im Hinblick auf die Unterschiede hierzu erläutert werden.

Bei der in Figur 4 gezeigten Bauelementanordnung 1 ist auf einem Träger 2 eine metallische Struktur 3 umfassend drei Teilbereiche 3a, 3b, 3c angeordnet. Die metallische Struktur 3 kann elektrisch kontaktiert sein (nicht-erfindungsgemäß) oder kann erfindungsgemäß elektrisch nicht kontaktiert sein.

Zwischen einem ersten und einem zweiten Teilbereich 3a, 3b ist eine Kavität 5a ausgebildet. In der Kavität 5a ist ein dritter Teilbereich 3c der metallischen Struktur 3 angeordnet. Der dritte Teilbereich 3c weist eine geringere Höhe auf als der erste und der zweite Teilbereich 3a, 3b. Zwischen dem ersten Teilbereich 3a und dem dritten Teilbereich 3c sowie zwischen dem zweiten Teilbereich 3b und dem dritten Teilbereich 3c sind Kavitäten 5b, 5c ausgebildet. Die Kavitäten 5b und 5c können auch als Teilbereiche der Kavität 5a angesehen werden.

In den Kavitäten 5b, 5c ist jeweils ein elektrisches Bauelement 6a, 6b angeordnet. Die Kavitäten 5a, 5b, 5c sind mit einem Schutzmaterial 13, insbesondere einem Isolationsmaterial, gefüllt. Das Schutzmaterial 13 kann als Schutzbeschichtung ausgebildet sein. Alternativ oder zusätzlich können die Kavitäten 5a, 5b, 5c mit einem Material zur Lichtkonvertierung gefüllt sein. Beispielsweise kann das Schutzmaterial 13 auch zur Lichtkonvertierung dienen. Insbesondere kann von einer LED erzeugtes blaues Licht in weißes Licht konvertiert werden. Beispielsweise wird hierzu ein Phosphormaterial verwendet.

Jeder der drei Teilbereiche 3a, 3b, 3c kann beispielsweise zur Kontaktierung eines elektrischen Elements (nicht-erfindungsgemäß) oder zur Wärmeabfuhr dienen.

Bei der in Figur 5 gezeigten Bauelementanordnung 1 umfasst die metallische Struktur 3 vier voneinander getrennte Teilbereiche 3a, 3b, 3c, 3d. Zwischen dem ersten und dem zweiten Teilbereich 3a, 3b befindet sich eine erste Kavität 5a, in der ein erstes elektrisches Bauelement 6a angeordnet ist. Ebenso befindet sich zwischen dem dritten und vierten Teilbereich 3c, 3d eine zweite Kavität 5b, in der ein zweites elektrisches Bauelement 6b angeordnet ist. Die ersten und zweiten elektrischen Bauelemente 6a, 6b sind auf Kontaktflächen 8 angeordnet und über die Kontaktflächen 8 elektrisch kontaktiert. Die Teilbereiche 3a, 3b, 3c, 3d der metallischen Struktur 3 sind ebenfalls auf den Kontaktflächen 8 angeordnet und mit den Kontaktflächen 8 elektrisch kontaktiert (nicht-erfindungsgemäß).

Zudem ist auf dem Träger 2 ein drittes Bauelement 6c, insbesondere ein Chip 14 angeordnet. Der Chip 14 ist beispielsweise ein Leuchtdiodenchip. Der Chip 14 ist in einer dritten Kavität 5c angeordnet, die durch den zweiten und dritten Teilbereich 3b, 3c der metallischen Struktur 3 gebildet wird. Der Chip 14 kann beispielsweise mittels Kontaktflächen, Vias oder einer Verdrahtung elektrisch kontaktiert sein.

Bei dem hier gezeigten Ausführungsbeispiel sind die elektrischen Bauelemente 6a, 6b und der Chip 14 auf der selben Außenseite 9 des Trägers 2 angeordnet. Die Außenseite 9 ist vorzugsweise eine Oberseite des Trägers 2. Somit kann beispielsweise bei einem als Leuchtdiodenchip ausgebildeten dritten Bauelement 6c Licht nach oben abgestrahlt werden. Die Versenkung der elektrischen Bauelemente 6a, 6b in den Kavitäten 5a, 5b verhindert, dass vom Leuchtdiodenchip abgestrahltes Licht durch die weiteren elektrischen Bauelemente 6a, 6b abgeschattet wird.

Die Seitenflächen der Teilbereiche 3c, 3b, die die Kavität 5c, in der der Chip 14 angeordnet ist, begrenzen, sind vorzugsweise reflektierend. Damit kann eine Lichtausbeute verbessert werden.

Vorzugsweise weist die metallische Struktur 3 eine hohe thermische Leitfähigkeit auf. Dies hat den Vorteil, dass im Betrieb erzeugte Wärme gut abgeführt werden kann.

Dadurch weist die Bauelementanordnung 1 ein gutes thermisches Management auf. Durch eine reduzierte Wärmebelastung kann die Lebensdauer der Bauelementanordnung 1 signifikant verlängert werden.

Die Kavitäten 5a, 5b, 5c sind mit einem Schutzmaterial 13 aufgefüllt. Das Schutzmaterial 13 bedeckt die metallische Struktur 3 und die Bauelemente 6a, 6b, 6c vollständig. Insbesondere bildet das Schutzmaterial 13 eine Schutzbeschichtung der Bauelementanordnung 1.

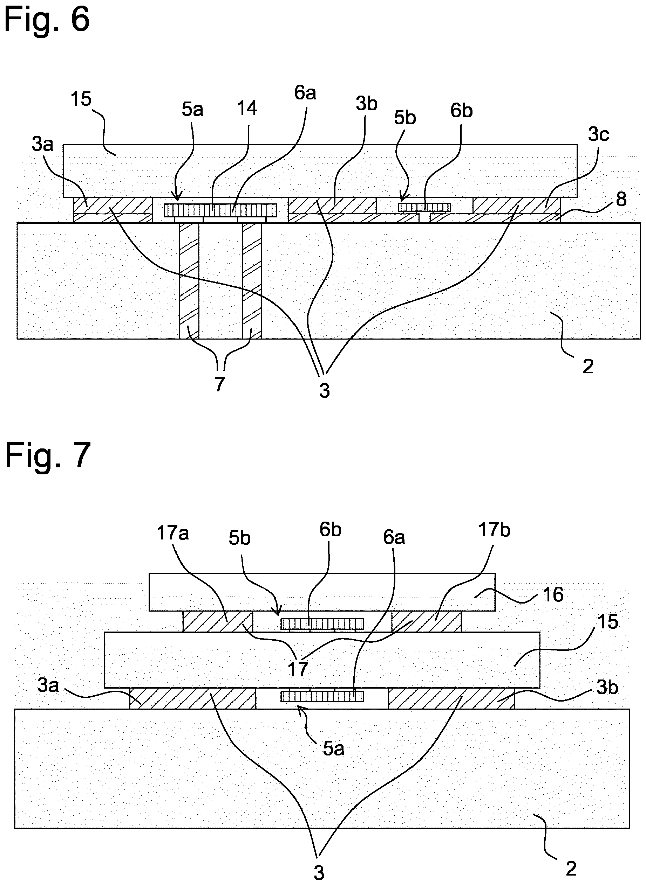

Die in Figur 6 gezeigte Bauelementanordnung 1 weist einen Träger 2 auf, auf dem eine metallische Struktur 3 umfassend einen ersten, zweiten und dritten Teilbereich 3a, 3b, 3c angeordnet ist. Der zweite Teilbereich 3b ist zwischen dem ersten und dem dritten Teilbereich 3a, 3c angeordnet. Alle Teilbereiche 3a, 3b, 3c weisen die gleiche Höhe auf.

In einer ersten Kavität 5a der metallischen Struktur 3 ist ein erstes Bauelement 6a angeordnet. Das erste Bauelement 6a kann als Chip, beispielsweise als Leuchtdiodenchip ausgebildet sein. Das erste Bauelement 6a ist über Vias 7 kontaktiert. Die Vias 7 können als thermische und/oder elektrische Vias ausgebildet sein. In einer zweiten Kavität 5b ist ein zweites Bauelement 6b angeordnet, das über Kontaktflächen 8 elektrisch kontaktiert ist.

Auf der metallischen Struktur 3 ist ein weiteres Element 15 angeordnet. Das weitere Element 15 überdeckt die in den Kavitäten 5a, 5b angeordneten Bauelemente 6a, 6b. Somit sind die Bauelemente 6a, 6b zwischen dem Träger 2 und dem weiteren Element 15 in den Kavitäten 5a, 5b eingebettet.

Das weitere Element 15 ist an der metallischen Struktur 3 befestigt, beispielsweise angelötet. Somit dient die metallische Struktur 3 insbesondere zur Befestigung des weiteren Elements 15. Zusätzlich dient die metallische Struktur 13 auch zur elektrischen Kontaktierung des weiteren Elements 15 (nicht-erfindungsgemäß). Zusätzlich oder alternativ kann auch eine Wärmeübertragung zwischen dem weiteren Element 15 und dem Träger 2 durch die metallische Struktur 3 ermöglicht werden.

Das weitere Element 15 bildet eine zweite Ebene der Bauelementanordnung. Der Träger 2 mit den darauf angeordneten Bauelementen 6a, 6b kann als erste Ebene der Bauelementanordnung 1 angesehen werden.

Mit der gezeigten Anordnung können Bauelemente 6a, 6b platzsparend in der Bauelementanordnung 1 untergebracht werden, da sie in zwischen den Ebenen angeordneten Kavitäten 5a, 5b versenkt werden.

Das weitere Element 15 ist beispielsweise als Träger ausgebildet. Insbesondere können auf dem weiteren Element 15 weitere Bauelemente aufgebracht sein. Das weitere Element 15 kann auch als Chip, insbesondere als Leuchtdiodenchip ausgebildet sein.

In Figur 7 ist eine Bauelementanordnung 1 mit drei Ebenen gezeigt. Auf einem Träger 2, der eine erste Bauelementebene bildet, ist ein erstes weiteres Element 15 und darauf ein zweites weiteres Element 16 angeordnet. Das erste weitere Element 15 bildet eine zweite Bauelementebene und das zweite weitere Element 16 bildet eine dritte Bauelementebene.

Das erste weitere Element 15 ist mit dem Träger 2 über eine metallische Struktur 3 aufweisend zwei Teilbereiche 3a, 3b elektrisch (nicht-erfindungsgemäß) und mechanisch verbunden. Das zweite weitere Element 16 ist mit dem ersten weiteren Element 15 über eine weitere metallische Struktur 17, aufweisend zwei Teilbereiche 17a, 17b elektrisch (nicht-erfindungsgemäß) und mechanisch verbunden. Die metallischen Strukturen 3, 17 können die wie zu Figur 6 beschriebenen strukturellen und funktionellen Eigenschaften aufweisen. Die weiteren Elemente 15, 26 können beispielsweise als elektrische Bauelemente ausgebildet sein. Die weiteren Elemente können als Chip, insbesondere als Leuchtdiodenchip oder als Träger ausgebildet sein. Insbesondere kann das zweite weitere Element 16 als Leuchtdiodenchip ausgebildet sein.

In den metallischen Strukturen 3, 17 sind jeweils Kavitäten 5a, 5b ausgebildet. In der Kavität 5a der ersten metallischen Struktur 3 ist ein erstes elektrisches Bauelement 6a eingebettet und in der Kavität 5b der zweiten metallischen Struktur 17 ist ein zweites elektrisches Bauelement 6b eingebettet. Im vorliegenden Beispiel sind beide elektrischen Bauelemente 6a, 6b an dem ersten weiteren Element 15 befestigt. Alternativ kann das erste Bauelement 6a am Träger 2 befestigt sein. Das zweite Bauelement 6b kann alternativ am zweiten weiteren Element 16 angeordnet sein.

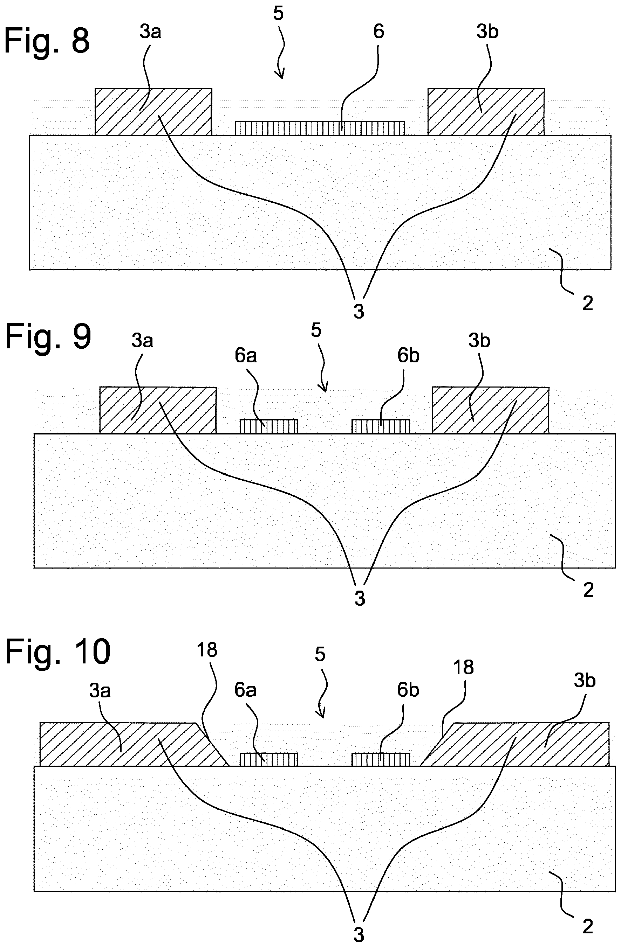

Die Figuren 8 bis 10 zeigen verschiedene Gestaltungsmöglichkeiten von metallischen Strukturen 3 und mögliche Anordnungen von diskreten Bauelementen 6a, 6b in Bauelementanordnungen 1. Die vorher beschriebenen Ausführungsbeispiele der Bauelementanordnungen 1 können entsprechend abgewandelt werden.

Figur 8 zeigt eine Ausführungsform einer Bauelementanordnung 1, bei dem ein diskretes Bauelement 6 in einer Kavität 5 einer metallischen Struktur 3 angeordnet ist. Das Bauelement 6 ist vollständig in der Kavität 5 versenkt.

Figur 9 zeigt eine Ausführungsform einer Bauelementanordnung 1, bei dem zwei diskrete Bauelemente 6a, 6b in einer Kavität 5 angeordnet sind. Die Bauelemente 6a, 6b sind vollständig in der Kavität 5 versenkt.

Figur 10 zeigt eine Ausführungsform einer Bauelementanordnung 1, bei dem die metallische Struktur 3 abgeschrägte Seitenflächen 18 aufweist. Dies kann beispielsweise zur Verbesserung der thermischen Eigenschaften führen. Für den Fall, dass wenigstens eines der Bauelemente 6a, 6b als Leuchtdiodenchip ausgebildet ist, kann hiermit eine verbesserte Abstrahlcharakteristik erzielt werden.

### Bezugszeichenliste

- 1: Bauelementanordnung
- 2: Träger
- 3: Struktur
- 3a: erster Teilbereich
- 3b: zweiter Teilbereich
- 3c: dritter Teilbereich
- 3d: vierter Teilbereich
- 4: erste Außenseite des Trägers
- 5: Kavität
- 5a: erste Kavität
- 5b: zweite Kavität
- 5c: dritte Kavität
- 6: elektrisches Bauelement
- 6a: erstes elektrisches Bauelement
- 6b: zweites elektrisches Bauelement
- 6c: drittes elektrisches Bauelement
- 7: Via
- 8: Kontaktfläche
- 9: zweite Außenseite des Trägers
- 10: Durchführung
- 11: Isolierung
- 11a: erste Isolierung
- 11b: zweite Isolierung
- 12: dünne Schicht
- 13: Schutzmaterial
- 14: Chip
- 15: weiteres Element
- 16: zweites weiteres Element
- 17: weitere metallische Struktur
- 17a, 17b: Teilbereiche der weiteren Struktur
- 18: Seitenfläche
- 19: Oberfläche
- 20: Grundkörper

- t: Tiefe der Kavität
- h₁: Höhe eines Teilbereichs
- h₂: Höhe des elektrischen Bauelements

## Patentansprüche

1. Bauelementanordnung mit einem Träger (2), der eine metallische Struktur (3, 17) aufweist, wobei die metallische Struktur (3, 17) wenigstens eine Kavität (5, 5a, 5b, 5c, 5d) aufweist, und mit wenigstens einem elektrischen Bauelement (6, 6a, 6b, 6c), das zumindest teilweise in der Kavität (5, 5a, 5b, 5c, 5d) angeordnet ist, bei der die metallische Struktur (3, 17) wenigstens zwei voneinander getrennte Teilbereiche (3a, 3b, 3c, 3d) aufweist, wobei sich die Kavität (5, 5a, 5b, 5c, 5d) zwischen den Teilbereichen (3a, 3b, 3c, 3d) befindet, charakterisiert dadurch, dass die metallische Struktur (3, 17) nicht mit einem elektrischen Kontakt verbunden ist.

2. Bauelementanordnung nach Anspruch 1, bei der das elektrische Bauelement (6, 6a, 6b, 6c) vollständig in der Kavität (5, 5a, 5b, 5c, 5d) versenkt ist.

3. Bauelementanordnung nach einem der vorhergehenden Ansprüche, bei der die Teilbereiche (3a, 3b, 3c, 3d) planare Oberflächen (19) aufweisen.

4. Bauelementanordnung nach einem der vorhergehenden Ansprüche, bei der das wenigstens eine elektrische Bauelement (6, 6a, 6b, 6c) als Thermistorelement, Varistorelement, TVS-Diode oder Leuchtdiode ausgebildet ist.

5. Bauelementanordnung nach einem der vorhergehenden Ansprüche, bei der das wenigstens eine elektrische Bauelement (6, 6a, 6b, 6c) als Chip (14) ausgebildet ist.

6. Bauelementanordnung nach einem der vorhergehenden Ansprüche, bei der die metallische Struktur (3, 17) mehrere Kavitäten (5, 5a, 5b, 5c, 5d) aufweist und wobei in jeder Kavität (5, 5a, 5b, 5c, 5d) wenigstens ein elektrisches Bauelement (6, 6a, 6b, 6c) angeordnet ist.

7. Bauelementanordnung nach einem der vorhergehenden Ansprüche, bei der in einer Kavität (5, 5a, 5b, 5c, 5d) mehrere elektrische Bauelemente (6, 6a, 6b, 6c) angeordnet sind.

8. Bauelementanordnung nach einem der vorhergehenden Ansprüche, bei der die Kavität (5, 5a, 5b, 5c, 5d) zumindest teilweise von einem weiteren Element (15, 16) überdeckt wird.

9. Bauelementanordnung nach Anspruch 8,
bei der das weitere Element (15, 16) als weiteres elektrisches Bauelement und/oder als weiterer Träger ausgebildet ist.

10. Bauelementanordnung nach einem der Ansprüche 8 oder 9, bei der die metallische Struktur (3, 17) zur Befestigung des weiteren Elements (15, 16) am Träger (2) ausgebildet ist.

11. Bauelementanordnung nach einem der vorhergehenden Ansprüche, bei der der Träger (2) einen isolierenden Grundkörper aufweist, der ein keramisches oder ein organisches Material aufweist.

## Claims

1. Component assembly having a carrier (2) which comprises a metallic structure (3, 17), wherein the metallic structure (3, 17) comprises at least one cavity (5, 5a, 5b, 5c, 5d), and having at least one electrical component (6, 6a, 6b, 6c) which is arranged at least in part in the cavity (5, 5a, 5b, 5c, 5d), where the metallic structure (3, 17) comprises at least two part regions (3a, 3b, 3c, 3d) which are separated from one another, wherein the cavity (5, 5a, 5b, 5c, 5d) is situated between the part regions (3a, 3b, 3c, 3d), **characterized in that** the metallic structure (3, 17) is not connected to an electrical contact.

2. Component assembly according to Claim 1, where the electrical component (6, 6a, 6b, 6c) is completely recessed in the cavity (5, 5a, 5b, 5c, 5d).

3. Component assembly according to either of the preceding claims, where the part regions (3a, 3b, 3c, 3d) comprise planar surfaces (19).

4. Component assembly according to one of the preceding claims, where the at least one electrical component (6, 6a, 6b, 6c) is realized as a thermistor element, varistor element, TVS diode or light-emitting diode.

5. Component assembly according to one of the preceding claims, where the at least one electrical component (6, 6a, 6b, 6c) is realized as a chip (14).

6. Component assembly according to one of the preceding claims, where the metallic structure (3, 17) comprises several cavities (5, 5a, 5b, 5c, 5d) and wherein at least one electrical component (6, 6a, 6b, 6c) is arranged in each cavity (5, 5a, 5b, 5c, 5d).

7. Component assembly according to one of the preceding claims, where several electrical components (6, 6a, 6b, 6c) are arranged in a cavity (5, 5a, 5b, 5c, 5d).

8. Component assembly according to one of the preceding claims, where the cavity (5, 5a, 5b, 5c, 5d) is covered at least in part by a further element (15, 16).

9. Component assembly according to Claim 8, where the further element (15, 16) is realized as a further electrical component and/or as a further carrier.

10. Component assembly according to either of Claims 8 to 9, where the metallic structure (3, 17) is realized for fastening the further element (15, 16) on the carrier (2).

11. Component assembly according to one of the preceding claims, where the carrier (2) comprises an insulating basic body which comprises a ceramic or an organic material.

## Revendications

1. Agencement de composants comprenant un support (2) pourvu d'une structure métallique (3, 17), la structure métallique (3, 17) comportant au moins une cavité (5, 5a, 5b, 5c, 5d) et au moins un composant électrique (6, 6a, 6b, 6c) qui est disposé au moins en partie dans la cavité (5, 5a, 5b, 5c, 5d), la structure métallique (3, 17) comportant au moins deux sous-régions (3a , 3b, 3c, 3d) séparées l'une de l'autre, la cavité (5, 5a, 5b, 5c, 5d) étant située entre les sous-régions (3a, 3b, 3c, 3d), **caractérisé en ce que** la structure métallique (3, 17) n'est pas reliée à un contact électrique.

2. Agencement de composants selon la revendication 1, dans lequel le composant électrique (6, 6a, 6b, 6c) est complètement enfoncé dans la cavité (5, 5a, 5b, 5c, 5d).

3. Agencement de composants selon l'une des revendications précédentes, dans lequel les sous-régions (3a, 3b, 3c, 3d) ont des surfaces planes (19).

4. Agencement de composants selon l'une des revendications précédentes, dans lequel l'au moins un composant électrique (6, 6a, 6b, 6c) est conçu comme un élément de thermistance, un élément de varistance, une diode TVS ou une diode électroluminescente.

5. Agencement de composants selon l'une des revendications précédentes, dans lequel l'au moins un composant électrique (6, 6a, 6b, 6c) est conçu comme une puce (14).

6. Agencement de composants selon l'une des revendications précédentes, dans lequel la structure métallique (3, 17) comporte une pluralité de cavités (5, 5a, 5b, 5c, 5d), au moins un composant électrique (6, 6a, 6b, 6c) étant disposé dans chaque cavité (5, 5a, 5b, 5c, 5d).

7. Agencement de composants selon l'une des revendications précédentes, dans lequel une pluralité de composants électriques (6, 6a, 6b, 6c) sont disposés dans une cavité (5, 5a, 5b, 5c, 5d).

8. Agencement de composants selon l'une des revendications précédentes, dans lequel la cavité (5, 5a, 5b, 5c, 5d) est recouverte au moins partiellement par un autre élément (15, 16) .

9. Agencement de composants selon la revendication 8, dans lequel l'autre élément (15, 16) est conçu comme un composant électrique supplémentaire et/ou comme un support supplémentaire.

10. Agencement de composants selon l'une des revendications 8 ou 9, dans lequel la structure métallique (3, 17) est conçue pour fixer l'élément supplémentaire (15, 16) au support (2).

11. Agencement de composants selon l'une des revendications précédentes, dans lequel le support (2) comporte un corps de base isolant comprenant une céramique ou un matériau organique.
